# EUROPEAN PATENT APPLICATION

(11) **EP 1 607 977 A2**
(43) Date of publication of application: **21.12.2005**
(21) Application number: 05253666.1
(22) Date of filing: 14.06.2005
(51) Int. Cl.: G11B 33/12

(54) **Electronic device with built-in disk device**

(30) Priority: 15.06.2004 JP 2004176786; 07.02.2005 JP 2005030691
(71) Applicant: ORION ELECTRIC CO., Ltd., Takefu-City, Fukui 915-8555 (JP)
(72) Inventor: Makara, Hiroyuki, c/o Orion Electric Co. Ltd., Takefu-city Fukui 915-8555 (JP); Okumura, Hikari, c/o Orion Electric Co. Ltd., Takefu-city Fukui 915-8555 (JP); Koyama, Toshimitsu, c/o Orion Electric Co. Ltd., Takefu-city Fukui 915-8555 (JP); Kobashi, Masakuni, c/o Orion Electric Co. Ltd., Takefu-city Fukui 915-8555 (JP); Sasaki, Takuya, c/o Orion Electric Co. Ltd., Takefu-city Fukui 915-8555 (JP); Kishizuka, Kenji, c/o Orion Electric Co. Ltd., Takefu-city Fukui 915-8555 (JP)
(74) Representative: Paget, Hugh Charles Edward

(57) **Abstract**

To provide an electronic device with a built-in disk device including a disk device and disk device control substrate arranged side by side capable of reducing problems caused when a flexible flat cable connected to a pickup section which is a movable section touches other members inside the device and reducing a load applied to a connection of the flexible flat cable.

In an FFC 23 provided with a slack portion 23a to absorb the moving distance of a pickup section 11a, the slack portion 23a is provided with a bending section 23b and bending section 23c bent in mutually opposite curving directions and the bending section 23b is stopped by an L-figured stopper 40 to thereby prevent a connection 12a from being affected by sliding of the pickup section 11a (load caused by the movement of the FFC near the connection).

## Description

### BACKGROUND OF THE INVENTION

### Field of the invention

The present invention relates to an electronic device with a built-in disk device, and more particularly, to an electronic device allowing for the routing of a flexible flat cable which electrically connects a substrate provided for a movable section in the disk device and a disk device control substrate.

### Description of the related art

In response to a variety of needs of users in recent years, use of disk devices is not limited to DVD players and CD players,
etc. , but extends over a wide range of applications, for example, disk devices are incorporated in television receivers and these electronic devices, etc., are becoming smaller and slimmer year after year.

A disk device is provided with a pickup section which moves to and fro in the radius direction of a disk medium to read and/or write a signal from/to the disk medium and the pickup section and a control substrate, etc . , are electrically connected via a wire such as a flexible flat cable to transmit a signal from the pickup section to the control substrate, etc. The flexible flat cable moves following reciprocating motion of the pickup section, but as described above, since the electronic device is becoming smaller and slimmer, when the flexible flat cable moves inside the device, it is likely to touch other parts, etc., inside the device, which leads to problems of blocking the movement of the pickup section and damaging the flexible flat cable itself.

Conventional technologies related to the above described routing of a flexible flat cable connected to a movable section are disclosed in Japanese Patent Laid-Open No. 2001-283497, Japanese Patent Laid-Open No. 2002-324389 and Japanese Patent Laid-Open No. 2003-100036, etc.

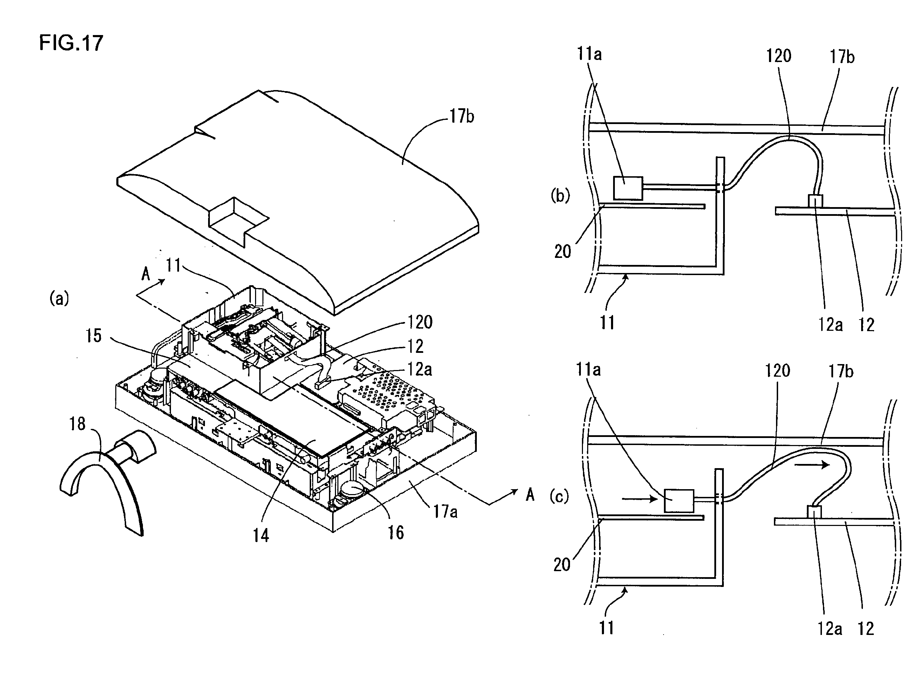

FIG. 17 illustrates an overview of a conventional electronic device (LCD with a built-in DVD) incorporating a disk device 11 and a disk device control substrate 12 arranged side by side, (a) is a rear perspective view with a cabinet removed, (b) and (c) are schematic views illustrating a routing condition of a flexible flat cable viewed from the direction indicated by an arrowed line A-A in FIG. 17(a). An end of the flexible flat cable 120 is connected to a pickup section 11a which moves to and fro in the radius direction of a disk medium 20 and the other end is connected to the disk device control substrate 12 fixed to the body of the device, and therefore the flexible flat cable 120 needs to have at least a length corresponding to a maximum relative distance (FIG. 17b) between the pickup section 11a and disk device control substrate 12, and the superfluous portion (slack portion) is bent (swells in the cabinet direction) when the distance between the pickup section 11a and the disk device control substrate 12 becomes a minimum (FIG. 17c). Inside a device designed to have a low profile such as an LCD, there is not enough space and so if the flexible flat cable is simply left sagging as shown in FIG. 17(b), (c), when the pickup section 11a in reciprocating motion approaches the disk device control substrate 12, the slack portion of the flexible flat cable 120 touches a cabinet 17b, which increase a load (bending moment) on the vicinity of a connection 12a between the flexible flat cable 120 and disk device control substrate 12, producing a possibility of causing a problem with the connection 12a. Furthermore, as the pickup section 11a moves to and fro, the flexible flat cable 120 touches the cabinet 17b rubbing against the cabinet 17b, producing a possibility of damaging the coating of the flexible flat cable 120 and blocking the movement of the pickup section 11a as well.

### SUMMARY OF THE INVENTION

In view of the above described problems, it is an object of the present invention to provide an electronic device with a built-in disk device including the disk device and a disk device control substrate arranged side by side, capable of reducing problems caused when a flexible flat cable connected to a pickup section which is a movable section touches other members inside the device and reducing a load on a connection of the flexible flat cable.

The electronic device with a built-in disk device according to a first aspect of the invention is an electronic device comprising a disk device which reads and/or writes a signal from/to a diskmedium and a disk device control substrate which controls and drives the disk device and controls a signal input/output to/from the disk device, said disk device and said disk device control substrate being arranged side by side, and a flexible flat cable which electrically connects a pickup section which moves to and fro in the radius direction of the disk medium to read and/or write a signal from the disk medium loaded in the disk device and the disk device control substrate,
characterized in that a slack portion provided for the flexible flat cable between the pickup section and the disk device control substrate to absorb the distance of reciprocating motion of the pickup section is provided with two ormore bending sections.

According to the above described structure, the movement of the slack portion of the flexible flat cable caused by movement of the side of the flexible flat cable connected to the pickup section following the reciprocating motion of the pickup section is absorbed by bending operations of the two or more bending sections provided for the slack portion.

The electronic device with a built-in disk device according to a second aspect of the invention is an electronic device comprising a disk device which reads and/or writes a signal from/to a disk medium and a disk device control substrate which controls and drives the disk device and controls a signal input/output to/from the disk device, said disk device and said disk device control substrate being arranged side by side, and a flexible flat cable which electrically connects a pickup section which moves to and fro in the radius direction of the disk medium to read and/or write a signal from the disk medium loaded in the disk device and the disk device control substrate,
characterized in that a slack portion is provided for the flexible flat cable between the pickup section and the disk device control substrate to absorb the distance of reciprocating motion of the pickup section and a stopping/retaining section for retaining the shape of the slack portion of the flexible flat cable is provided at a connection point between the disk device control substrate and the flexible flat cable.

According to the above described structure, the movement of the slack portion of the flexible flat cable caused by the movement of the flexible flat cable (side connected to the pickup section) following the reciprocating motion of the pickup section is absorbed by the stopping/retaining section.

The electronic device with a built-in disk device according to a third aspect of the invention is the electronic device with a built-in disk device according to the first or second aspect of the invention, characterized in that the slack portion of the flexible flat cable is provided with bending sections and the bending sections have opposite curving directions so that the flexible flat cable becomes substantially a sigmoid curve.

The electronic device with a built-in disk device according to a fourth aspect of the invention is the electronic device with a built-in disk device according to the first or second aspect of the invention, characterized in that the slack portion of the flexible flat cable is provided with bending sections and the bending sections have the same curving direction so that the flexible flat cable becomes substantially spiral.

The electronic device with a built-in disk device according to a fifth aspect of the invention is the electronic device with a built-in disk device according to any one of the first to fourth aspects of the invention, characterized in that the stopping/retaining section which retains the shape of the slack portion of the flexible flat cable is formed using an L-figured stopper.

The electronic device with a built-in disk device according to a sixth aspect of the invention is the electronic device with a built-in disk device according to any one of the first to fourth aspects of the invention, characterized in that the stopping/retaining section which retains the shape of the slack portion of the flexible flat cable is formed so as to allow the flexible flat cable to pass through a slit provided on a side of a frame which forms an outer frame of the disk device.

The electronic device with a built-in disk device according to a seventh aspect of the invention is the electronic device with a built-in disk device according to any one of the first to fourth aspects of the invention, characterized in that the stopping/retaining section which retains the shape of the slack portion of the flexible flat cable is formed using a hook provided on a side of a frame which forms an outer frame of the disk device.

The electronic device with a built-in disk device according to an eighth aspect of the invention is the electronic device with a built-in disk device according to any one of the second to fifth aspects of the invention, the flexible flat cable retained by the stopping/retaining section being disposed between an inner wall surface of a cabinet which constitutes a housing of the electronic device with a built-in disk device and an end of a frame side piece which forms an outer frame of the disk device, characterized in that convex parts which exceed in height at least the thickness of the flexible flat cable are formed at parts of the stopping/retaining section facing the end of the frame side piece which forms the outer frame of the disk device.

According to the above described structure, the convex parts which exceed in height at least the thickness of the flexible flat cable are formed at parts of the stopping/retaining section facing the end of the frame side piece which forms the outer frame of the disk device. Therefore, even in the case where a load is applied to the housing from the outside of the electronic device, the cabinet making up the housing is bent in an inward direction of the device, the inner wall surface side of the cabinet touches the stopping/retaining section and the stopping/retaining section is thereby bent in the direction in which the stopping/retaining section touches the end of the frame side piece, the convex parts formed in the stopping/retaining section contact the end of the frame side piece, which prevents the flexible flat cable from being caught between the stopping/retaining section and the end of the frame side piece.

The electronic device with a built-in disk device according to a ninth aspect of the invention is the electronic device with a built-in disk device according to any one of the second to fifth aspects of the invention, with the flexible flat cable retained by the stopping/retaining section disposed between an inner wall surface of a cabinet which constitutes a housing of the electronic device with a built-in disk device and an end of a frame side piece which forms an outer frame of the disk device, characterized in that convex parts which exceed in height at least the thickness of the flexible flat cable are formed at parts facing the stopping/retaining section at an end of the frame side piece which forms the outer frame of the disk device.

According to the above described structure, convex parts which exceed in height at least the thickness of the flexible flat cable are formed at parts facing the stopping/retaining section at an end of the frame side piece which forms the outer frame of the disk device. Therefore, even in the case where a load is applied to the housing from the outside of the electronic device, the cabinet making up the housing is bent in an inward direction of the device, the inner wall surface side of the cabinet touches the stopping/retaining section and the stopping/retaining section is thereby bent in the direction in which the stopping/retaining section touches the end of the frame side piece, the convex parts formed at the end of the frame side piece contact the stopping/retaining section, which prevents the flexible flat cable from being caught between the stopping/retaining section and the end of the frame side piece.

The electronic device with a built-in disk device according to a tenth aspect of the invention is the electronic device with a built-in disk device according to any one of the second to fifth aspects of the invention, the flexible flat cable retained by the stopping/retaining section being disposed between an inner wall surface of a cabinet which constitutes a housing of the electronic device with a built-in disk device and an end of a frame side piece which forms an outer frame of the disk device, characterized in that convex parts which exceed in height at least the thickness of the flexible flat cable are formed on the side of the stopping/retaining section facing the inner wall surface of the cabinet.

According to the above described structure, convex parts which exceed in height at least the thickness of the flexible flat cable are formed on the side of the stopping/retaining section facing the inner wall surface of the cabinet. Therefore, even in the case where a load is applied to the housing from the outside of the electronic device, the cabinet making up the housing is bent in an inward direction of the device, the inner wall surface side of the cabinet is thereby bent in the direction in which the inner wall surface side of the cabinet touches the stopping/retaining section, the convex parts formed in the stopping/retaining section contact the inner wall surface side of the cabinet, which prevents the flexible flat cable from being caught between the stopping/retaining section and the inner wall surface side of the cabinet.

The electronic device with a built-in disk device according to an eleventh aspect of the invention is the electronic device with a built-in disk device according to any one of the first to seventh aspects of the invention, the flexible flat cable being disposed between an inner wall surface of a cabinet which constitutes a housing of the electronic device with a built-in disk device and an end of a frame side piece which forms an outer frame of the disk device, characterized in that convex parts which exceed in height at least the thickness of the flexible flat cable disposed between the inner wall surface of the cabinet and the end of the frame side piece or the thickness of the flexible flat cable and the stopping/retaining section are formed at the end of the frame side piece which forms the outer frame of the disk device.

According to the above described structure, convex parts which exceed in height at least the thickness of the flexible flat cable disposed between the inner wall surface of the cabinet and the end of the frame side piece or the thickness of the flexible flat cable and the stopping/retaining section are formed at the end of the frame side piece which forms the outer frame of the disk device. Therefore, even in the case where a load is applied to the housing from the outside of the electronic device, the cabinet making up the housing is bent in an inward direction of the device, the inner wall surface side of the cabinet is thereby bent in the direction in which the inner wall surface side of the cabinet touches the stopping/retaining section, the convex parts formed at the end of the frame side piece contact the inner wall surface side of the cabinet, which prevents the flexible flat cable from being caught between the stopping/retaining section and the end of the frame side piece or between the stopping/retaining section and the inner wall surface side of the cabinet.

The electronic device with a built-in disk device according to a twelfth aspect of the invention is the electronic device with a built-in disk device according to any one of the first to seventh aspects of the invention, the flexible flat cable being disposed between an inner wall surface of a cabinet which constitutes a housing of the electronic device with a built-in disk device and an end of a frame side piece which forms an outer frame of the disk device, characterized in that convex parts which exceed in height at least the thickness of the flexible flat cable disposed between the inner wall surface of the cabinet and the end of the frame side piece or the thickness of the flexible flat cable and the stopping/retaining section are formed at parts of the inner wall surface of the cabinet facing the end of the frame side piece which forms the outer frame of the disk device.

According to the above described structure, convex parts which exceed in height at least the thickness of the flexible flat cable disposed between the inner wall surface of the cabinet and the end of the frame side piece or the thickness of the flexible flat cable and the stopping/retaining section are formed at parts of the inner wall surface of the cabinet facing the end of the frame side piece which forms the outer frame of the disk device. Therefore, even in the case where a load is applied to the housing from the outside of the electronic device, the cabinet making up the housing is bent in an inward direction of the device, the inner wall surface side of the cabinet is thereby bent in the direction in which the inner wall surface side of the cabinet touches the stopping/retaining section, the convex parts formed on the inner wall surface of the cabinet contact the end of the frame side piece, which prevents the flexible flat cable from being caught between the stopping/retaining section and the end of the frame side piece or between the stopping/retaining section and the inner wall surface side of the cabinet.

According to the electronic device with a built-in disk device according to a first aspect of the invention comprising a disk device which reads and/or writes a signal from/to a disk medium and a disk device control substrate which controls and drives the disk device and controls a signal input/output to/from the disk device, said disk device and said disk device control substrate being arranged side by side, and a flexible flat cable which electrically connects a pickup section which moves to and fro in the radius direction of the disk medium to read and/or write a signal from the disk medium loaded in the disk device and the disk device control substrate, characterized in that a slack portion provided for the flexible flat cable between the pickup section and the disk device control substrate to absorb the distance of reciprocating motion of the pickup section is provided with two or more bending sections, the movement of the slack portion of the flexible flat cable caused by reciprocating motion of the pickup section is absorbed by bending operations of the two or more bending sections provided for the flexible flat cable, and therefore the movement of the slack portion of the flexible flat cable is hardly transmitted to the connection between the disk device control substrate and the flexible flat cable. This prevents a load from applying to the connection between the disk device control substrate and flexible flat cable.

According to the electronic device with a built-in disk device according to a second aspect of the invention comprising a disk device which reads and/or writes a signal from/to a disk medium and a disk device control substrate which controls and drives the disk device and controls a signal input/output to/from the disk device, said disk device and said disk device control substrate being arranged side by side, and a flexible flat cable which electrically connects a pickup section which moves to and fro in the radius direction of the disk medium to read and/or write a signal from the disk medium loaded in the disk device and the disk device control substrate,
characterized in that a slack portion is provided for the flexible flat cable between the pickup section and the disk device control substrate to absorb the distance of reciprocating motion of the pickup section and a stopping/retaining section for retaining the shape of the slack portion of the flexible flat cable is provided at a connection point between the disk device control substrate and the flexible flat cable, the movement of the slack portion of the flexible flat cable produced following the reciprocating motion of the pickup section is absorbed by the stopping/retaining section, preventing a load from applying to the connection between the disk device control substrate and the flexible flat cable.

According to the electronic device with a built-in disk device according to an eighth aspect of the invention, which is the electronic device with a built-in disk device according to any one of the second to fifth aspects of the invention, the flexible flat cable retained by the stopping/retaining section being disposed between an inner wall surface of a cabinet which constitutes a housing of the electronic device with a built-in disk device and an end of a frame side piece which forms an outer frame of the disk device, characterized in that convex parts which exceed in height at least the thickness of the flexible flat cable are formed at parts of the stopping/retaining section facing the end of the frame side piece which forms the outer frame of the disk device, even in the case where a load is applied to the housing from the outside of the electronic device, the cabinet making up the housing is bent in an inward direction of the device, the inner wall surface side of the cabinet touches the stopping/retaining section and the stopping/retaining section is thereby bent in the direction in which the stopping/retaining section touches the end of the frame side piece, the convex parts formed in the stopping/retaining section contact the end of the frame side piece, which prevents the flexible flat cable from being caught between the stopping/retaining section and the end of the frame side piece. This can prevent problems of causing an adverse influence on the operation of the pickup section by the flexible flat cable being caught between the stopping/retaining section and the end of the frame side piece, imposing a load on each member connected to the flexible flat cable and damaging the flexible flat cable itself.

### BRIEF DESCRIPTION OF THE DRAWINGS

FIG. 1 is a perspective view of a liquid crystal display device with a built-in disk device according to Embodiment 1.
FIG. 2 is a perspective view showing the liquid crystal display device with a built-in disk device according to Embodiment 1 with a back cabinet removed.
FIG. 3 is a rear view showing the liquid crystal display device with a built-in disk device according to Embodiment 1 with the back cabinet removed.
FIG. 4 illustrates a stopper, (a) : a side view of a stopper 40, (b): front view, (c): a top view, (d): a perspective view.
FIG. 5 is a schematic view illustrating the routing of an FFC of Embodiment 1.
FIG. 6 is a perspective view showing a liquid crystal display device with a built-in disk device according to Embodiment 2 with a back cabinet removed.
FIG. 7 is a schematic view illustrating the routing of an FFC of Embodiment 2.
FIG. 8 is a perspective view showing a liquid crystal display device with a built-in disk device according to Embodiment 3 with a back cabinet removed.
FIG. 9 is a schematic view illustrating the routing of an FFC of Embodiment 3.
FIG. 10 is a schematic view illustrating the routing of an FFC.
FIG. 11 illustrates a stopper according to Embodiment 4, (a): a top perspective view, (b): bottom perspective view, (c): a schematic view illustrating the routing of the FFC.
FIG. 12 is a schematic view illustrating conditions of a stopper and FFC inside the device when a load is applied from the outside of the cabinet.
FIG. 13 illustrates a disk device according to Embodiment 5, (a): a top perspective view, (b): a schematic view illustrating the routing of an FFC.
FIG. 14 is a schematic view illustrating conditions of a stopper and FFC inside the device when a load is applied from the outside of the cabinet.
FIG. 15 illustrates a stopper according to Embodiment 6.
FIG. 16 illustrates a disk device according to Embodiment 7, (a): a top perspective view, (b): a schematic view illustrating conditions of a stopper and FFC inside the device when a load is applied from the outside of the cabinet.
FIG. 17 is a schematic view illustrating the routing of an FFC of a liquid crystal display device with a built-in disk device in a conventional example.

### DETAILED DESCRIPTION OF THE PREFERRED EMBODIMENTS

With reference now to the attached drawings, embodiments of the present invention will be explained below. The following embodiments are only examples when implementing the present invention and not intended to limit the present invention to within the scope thereof.

### [Embodiment 1]

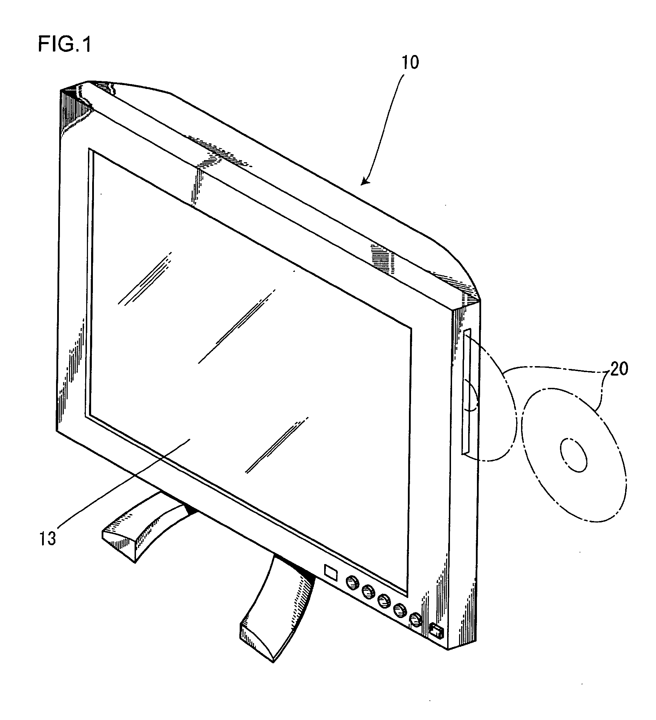

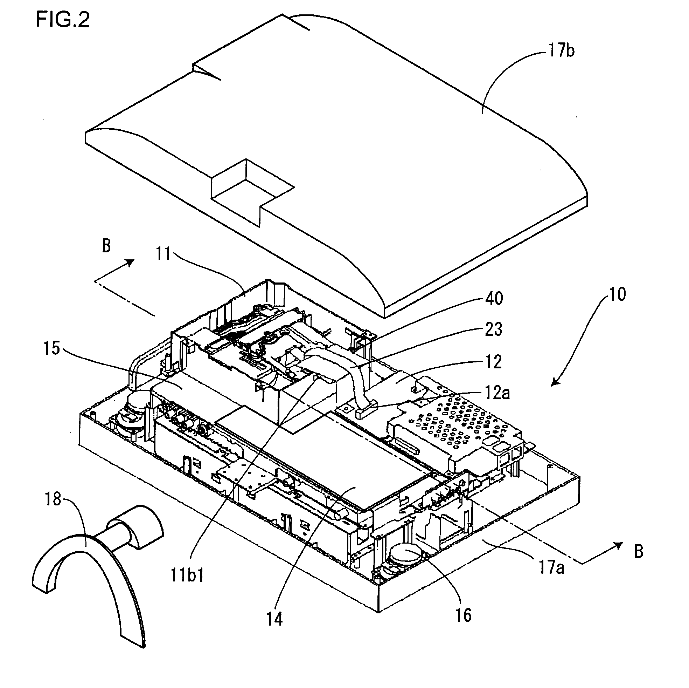

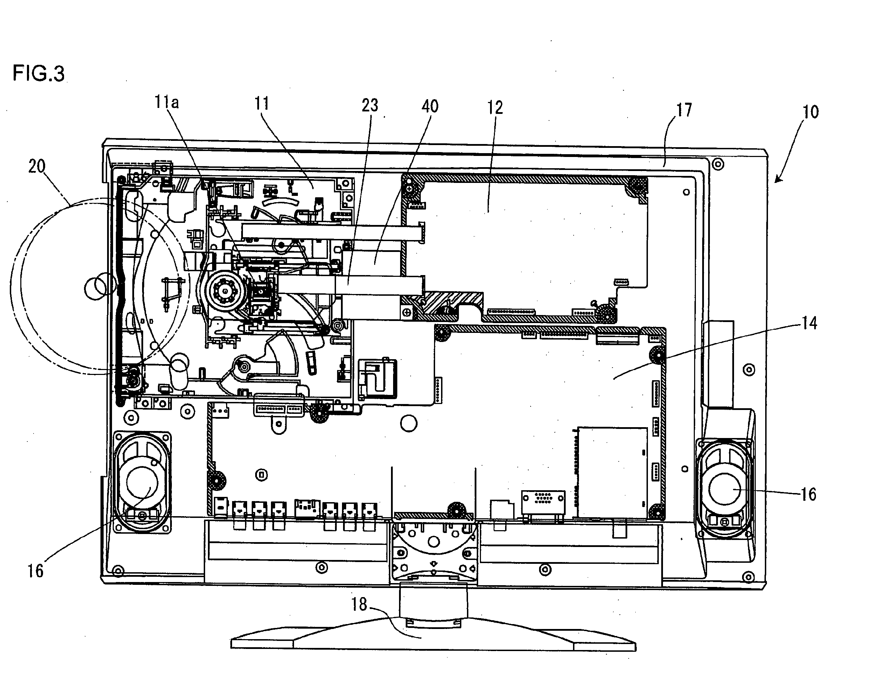

FIG. 1 is a perspective view of a liquid crystal display device with a built-in disk device according to this embodiment, FIG. 2 is a perspective view of the liquid crystal display device with a back cabinet removed and FIG. 3 is a rear view thereof.

As shown in FIG. 1 to FIG. 3, the liquid crystal display device 10 with a built-in disk device (hereinafter simply referred to as "LCD 10") according to this embodiment is constructed of a disk device 11, a disk device control substrate 12, an LCD module (not shown), a main control substrate 14, a chassis 15, a speaker 16, etc., all of which are housed in a housing 17. The housing 17 is constructed of a front cabinet 17a and a back cabinet 17b. As shown in FIG. 2 and FIG. 3, the disk device 11 and disk device control substrate 12 are arranged side by side and a flexible flat cable (hereinafter simply referred to as "FFC") 23 for transmitting a signal from a pickup section 11a provided for the disk device 11 to the disk device control substrate 12 is connected to the pickup section 11a and the disk device control substrate 12 through a slit 11b1 provided in a frame side 11b of the disk device 11. The outer frame of the disk device 11 is generally a resin frame.

The disk device 11 is provided with the pickup section 11a, etc. , which moves to and fro in the radius direction of an optical disk medium 20 to read and/or write a signal from/to the optical disk medium 20 and the disk device control substrate 12 is a substrate which controls a drive motor, etc. , provided for the disk device 11 or controls a signal input/output to/from the pickup section 11a. An LCD module is provided with a liquid crystal panel 13 which is a display device, a liquid crystal panel drive circuit which controls and drives the liquid crystal panel, a backlight which is a light source and an inverter circuit which controls and drives the backlight, and the main control substrate 14 controls the LCD module and processes/controls, etc., a video/speech signal. The main control substrate 14 and disk device control substrate 12 are shown in a simplified form in the figure, but they have a structure including various electric/electronic parts mounted on a printed circuit board on which a circuit pattern is printed.

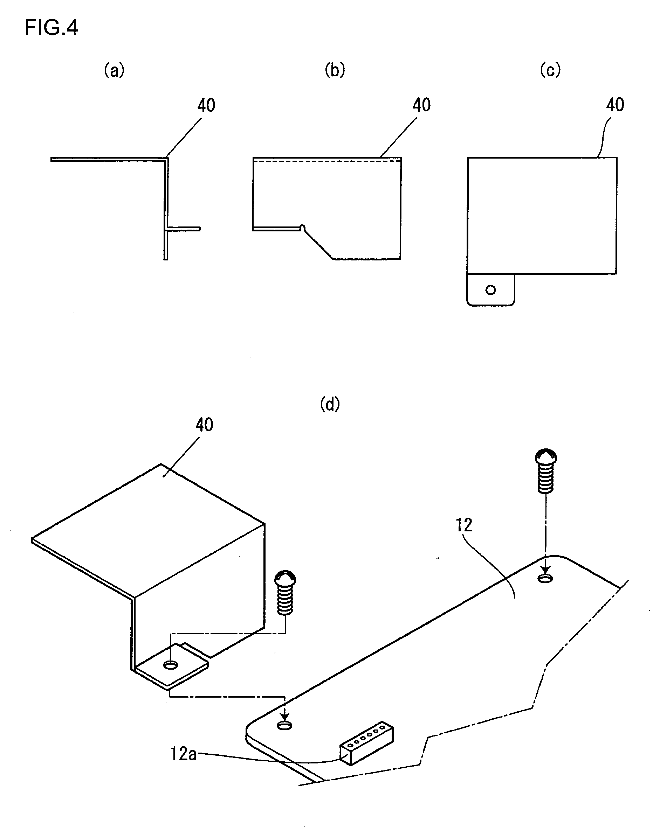

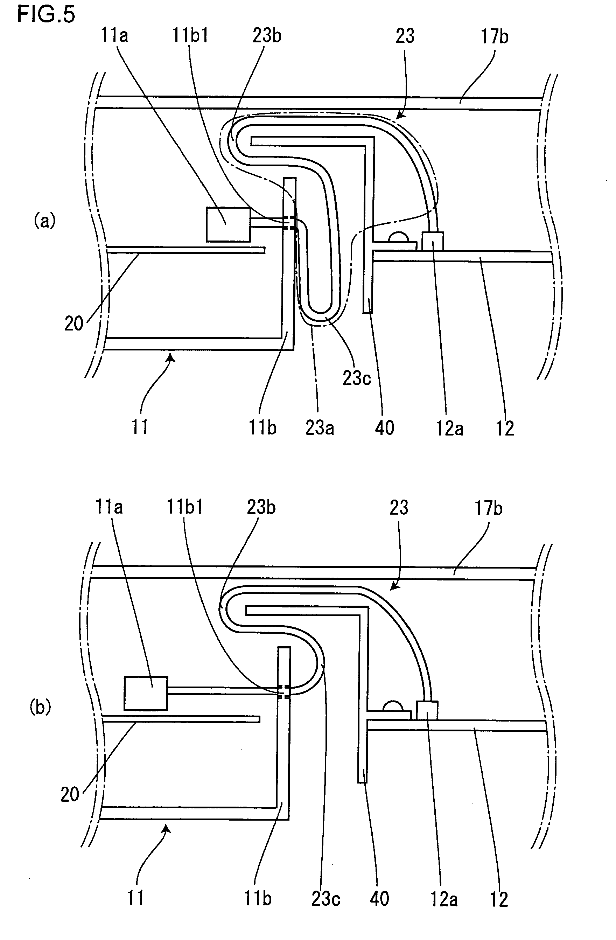

FIG. 4 shows a stopper provided for the disk device control substrate 12 to retain the shape of the FFC 23, (a) is a side view of the stopper 40, (b) is a front view and (c) is a top view. (d) is a perspective view of the stopper 40 and shows how it is attached to the disk device control substrate 12. As shown in the figure, the stopper 40 is fixed together with the disk device control substrate 12 using a screw for attaching the disk device control substrate 12 to the chassis 15. FIG. 5 is a schematic view illustrating the routing of the FFC 23 which connects the disk device control substrate 12 provided with the stopper 40 to the pickup section 11a viewed from the direction indicated by an arrowed line B-B in FIG. 2. FIG. 5 (a) is a schematic view when the disk device control substrate 12 and pickup section 11a are located closest to each other. FIG. 5(b) is a schematic view when the two are located farthest from each other. As shown in FIG. 5, the FFC 23 is provided with a slack portion 23a to absorb the moving distance of the pickup section 11a and the slack portion 23a is provided with a bending section 23b and a bending section 23c bent in mutually opposite curving directions, which causes the FFC 23 to have a substantially S-figure. The FFC 23 is stopped at the bending section 23b by the L-figured stopper 40.

According to the LCD 10 of the present invention, as shown in FIG. 5, the movement of the slack portion 23a of the FFC 23 caused by reciprocating motion of the pickup section 11a is absorbed by the stopper 40 and bending section 23b and bending section 23c, which drastically prevents the influence of the movement of the pickup section 11a from transmitting to a connection 12a. This drastically reduces the possibility seen in the conventional example (FIG. 17(b), (c)) that movement of the pickup section may cause a load to be applied to the connection 12a and repetition of this movement may cause trouble (breakage of electrical connection, etc.) with the connection 12a. Furthermore, since there is substantially no movement of the cable from the bending section 23b to the connection 12a where the shape of the cable is retained by the stopper 40, the FFC 23 does not move while touching (rubbing against) the back cabinet 17b, which also prevents damage to the coating of the FFC 23. Furthermore, the range of movement of the portion of the FFC 23 which moves (especially the part close to the bending section 23c) is limited to within the space between the frame side 11b of the disk device 11 and the stopper 40, and therefore it is possible to prevent a problem that the FFC 23 may be hooked by other members inside the device.

### [Embodiment 2]

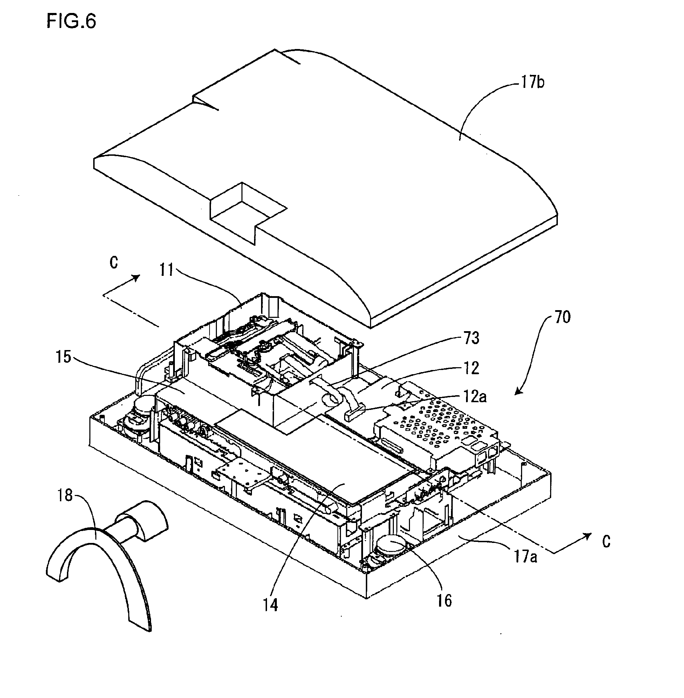

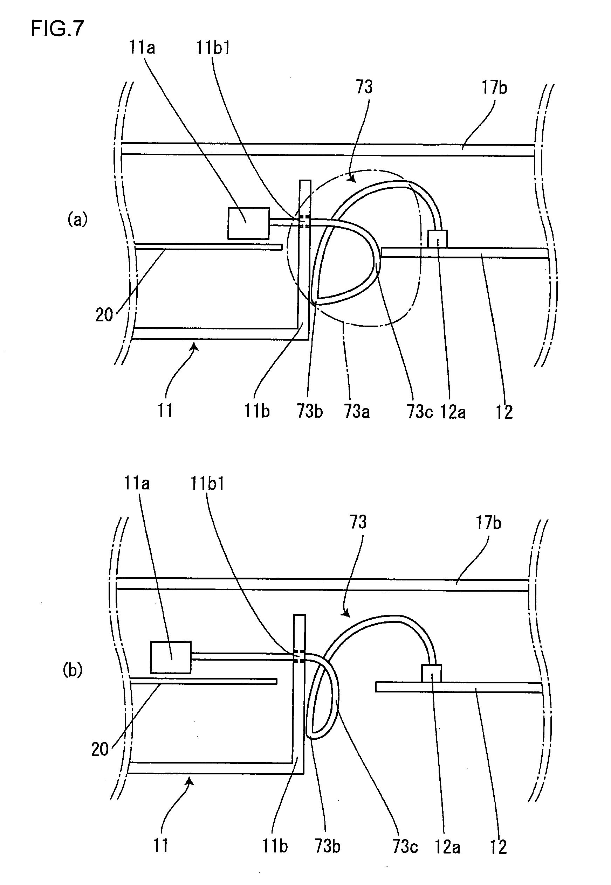

FIG. 6 is a perspective view showing a liquid crystal display device with a built-in disk device according to this embodiment with a back cabinet thereof removed, FIG. 7 is a schematic view illustrating the routing of an FFC which connects a disk device control substrate and a pickup section provided for the disk device viewed from the direction indicated by an arrowed line C-C in FIG. 6. FIG. 7(a) is a schematic view when the disk device control substrate and pickup section are located closest to each other and FIG. 7(b) is a schematic view when the two are located farthest from each other. The components similar to those in Embodiment 1 are assigned the same reference numerals as those in Embodiment 1 and explanations thereof will be omitted here.

As shown in FIG. 6 and FIG. 7, the FFC 73 is provided with a slack portion 73a to absorb the moving distance of a pickup section 11a and the slack portion 73a is provided with a bending section 73b and a bending section 73c bent in the same curving direction, which causes the FFC 73 to have substantially a spiral shape (the figure shows the bending section 73b and bending section 73c having different curvatures to make a clear distinction between the two, but the bending section 73b and bending section 73c may also have substantially the same curvature so that the bending section 73b and bending section 73c substantially form a continuous arc). As shown in FIG. 7, according to the LCD 70 of the present invention, the movement of the slack portion 73a of the FFC 73 produced by reciprocating motion of the pickup section 11a is absorbed by the bending section 73b and bending section 73c, and therefore a load on a connection 12a is reduced. Furthermore, since the FFC 73 does not swell toward the back cabinet 17b, it is possible to prevent the FFC 73 from touching the back cabinet 17b and make the LCD 70 as thin as possible. Moreover, implementing the present invention requires no additional member, which contributes to a cost reduction.

It is also possible to form a stopper such as a hook in the part of the disk device 11 where the side 11b almost contacts the FFC 73 (vicinity of the bending section 73b in FIG. 7) so as to stop the FFC 73. Such a structure can further reduce the load on the connection 12a.

### [Embodiment 3]

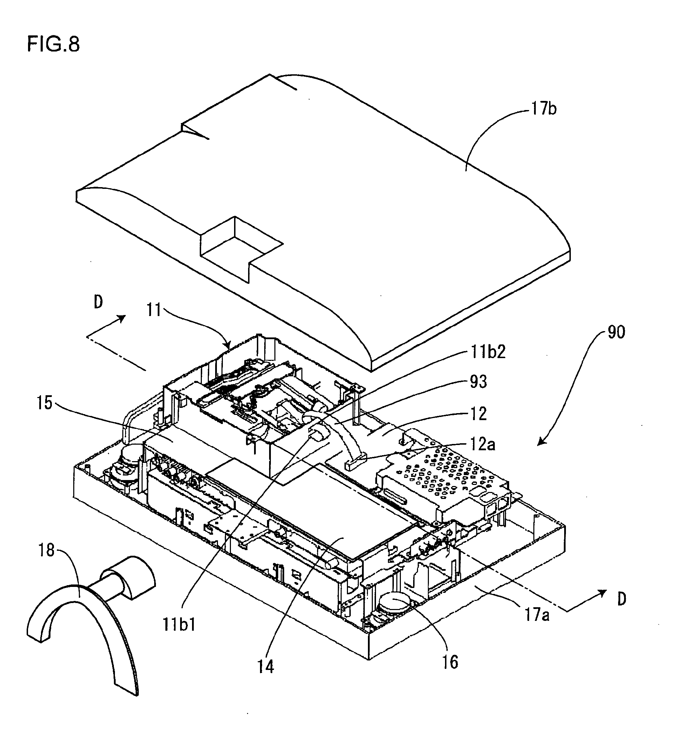

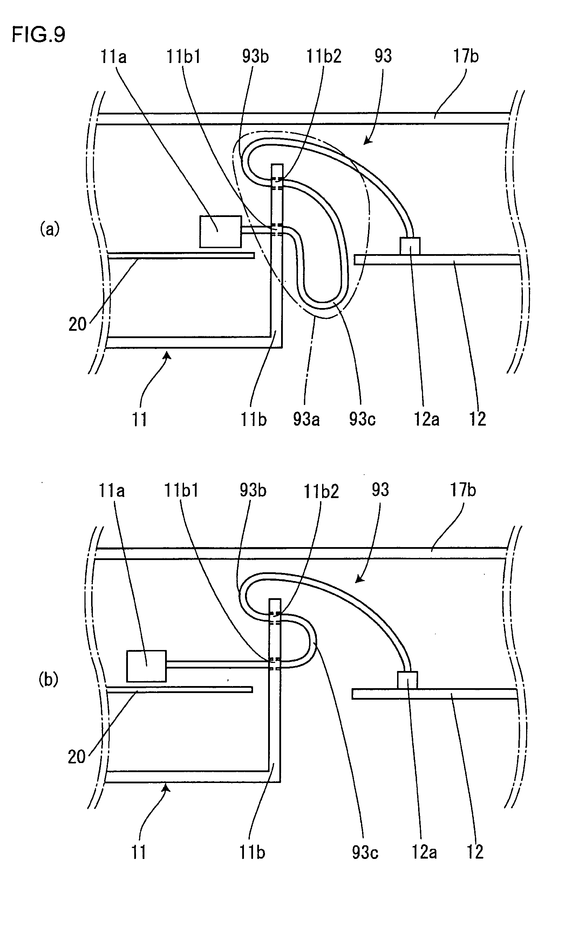

FIG. 8 is perspective view of a liquid crystal display device with a built-in disk device according to this embodiment with a back cabinet thereof removed, FIG. 9 is a schematic view illustrating the routing of an FFC which connects a disk device control substrate and a pickup section provided for the disk device viewed from the direction indicated by an arrowed line D-D in FIG. 8. FIG. 9(a) is a schematic view when the disk device control substrate and pickup section are located closest to each other and FIG. 9(b) is a schematic view when the two are located farthest from each other. The components similar to those in Embodiment 1 are assigned the same reference numerals as those in Embodiment 1 and explanations thereof will be omitted here.

As shown in FIG. 8 and FIG. 9, the FFC 93 is provided with a slack portion 93a to absorb the moving distance of a pickup section 11a and the slack portion 93a is provided with a bending section 93b and a bending section 93c bent in mutually opposite curving directions, which causes the FFC 93 to become substantially a sigmoid curve. The FFC 93 is stopped by being passed through a slit 11b2 provided in a frame side 11b of a disk device 11 in the vicinity of the bending section 93b. As shown in FIG. 9, according to the LCD 90 of the present invention, the movement of the slack portion 93a of the FFC 93 caused by reciprocating motion of the pickup section 11a is absorbed by the frame side piece 11b of the disk device 11, bending section 93b and bending section 93c, and therefore a load on a connection 12a is reduced.

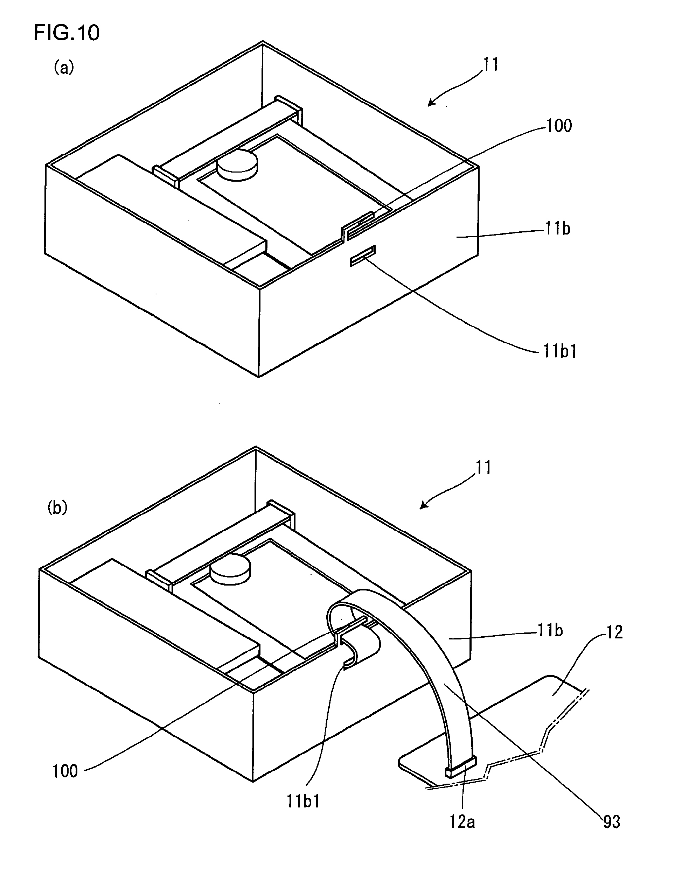

Another structure of the stopping/retaining section which retains the shape of the FFC 93 may be formed by providing a hook 100 as shown in FIG. 10 in the frame side piece 11b of the disk device 11. By so doing, it is possible to achieve the same effect of reducing the load on the connection 12a and improve operability of the work of attaching the FFC 93.

### [Embodiment 4]

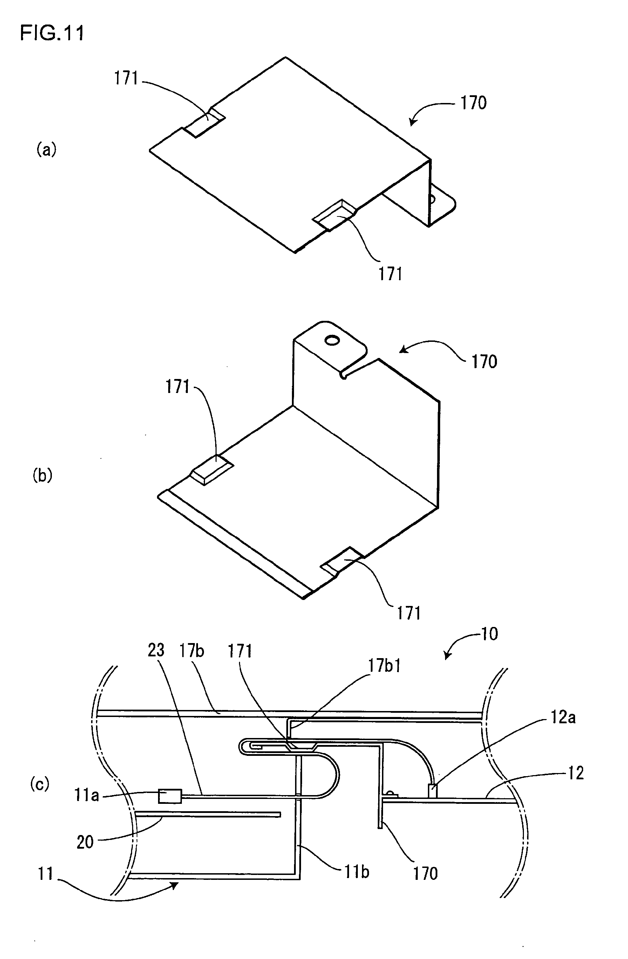

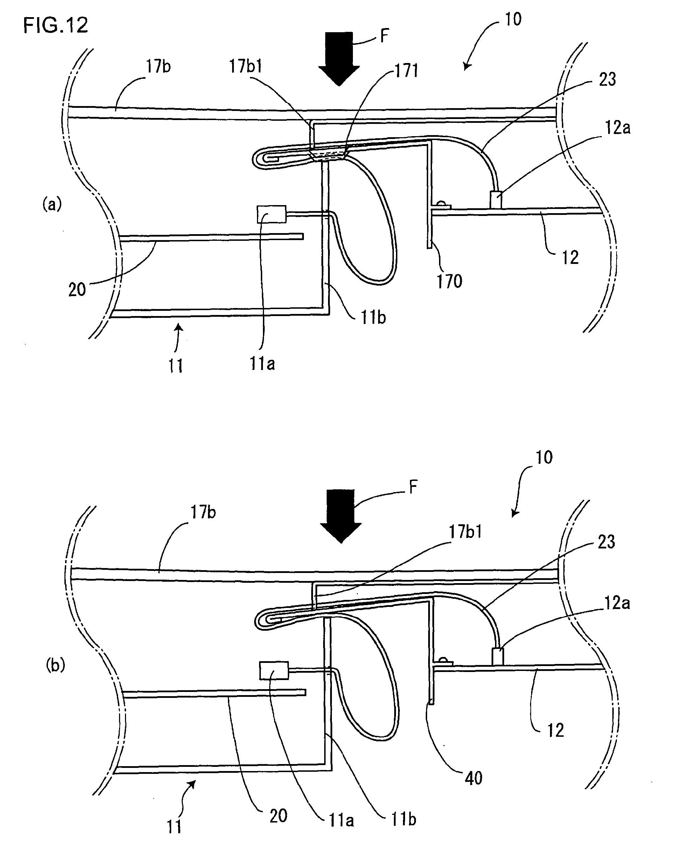

FIG. 11 shows a stopper provided for a disk device control substrate for retaining the shape of an FFC, FIG. 11(a) is a top perspective view, (b) is a bottom perspective view and (c) is a schematic view illustrating the routing of the FFC which connects the disk device control substrate and a pickup section provided for the disk device. FIG. 12 is a schematic view illustrating conditions of the stopper and the FFC inside the device when a load is applied from the outside to the back cabinet of the liquid crystal display device with a built-in disk device. Since the basic structure of the liquid crystal display device with a built-in disk device of this embodiment is the same as that of Embodiment 1 except the stopper, the same components as those of Embodiment 1 are assigned the same reference numerals as those in Embodiment 1 and explanations thereof will be omitted here.

As shown in FIGS. 11(a) and (b), the stopper 170 corresponds to the stopper 40 shown in Embodiment 1 with convex parts 171 formed at parts thereof through drawing. As shown in FIG. 11(c), when placed inside the LCD 10, the convex parts 171 are formed at positions facing the top end (end of the frame side piece) of the frame side piece 11b of the disk device 11 in such a way as to exceed in height the thickness of the FFC 23.

As shown in FIG. 12(b), in the case of the stopper 40 with no convex part formed therein, when a load F is applied from the outside to the back cabinet 17b of the LCD 10, the back cabinet 17b is bent in an inward direction of the device, a member 17b1 formed on the inner wall surface side of the back cabinet 17b touches the stopper 40 and when the stopper 40 is further bent so as to touch the top end of the frame side piece 11b, the FFC 23 is caught between the stopper 40 and frame side piece 11b, which may block the operation of the pickup section 11a or impose a load on each member (e.g., load on the mechanism for moving the pickup section 11a to and fro caused by the blocking of the operation of the pickup section 11a). On the other hand, in the case of the stopper 170 of this embodiment, as shown in FIG. 12(a), the convex parts 171 formed in the stopper 170 contact the top end of the frame side piece 11b preventing the FFC 23 from being caught between the stopper 170 and frame side piece 11b. This can prevent problems of causing an adverse influence on the operation of the pickup section 11a, imposing a load on each member connected to the FFC 23 and damaging the FFC 23 itself.

### [Embodiment 5]

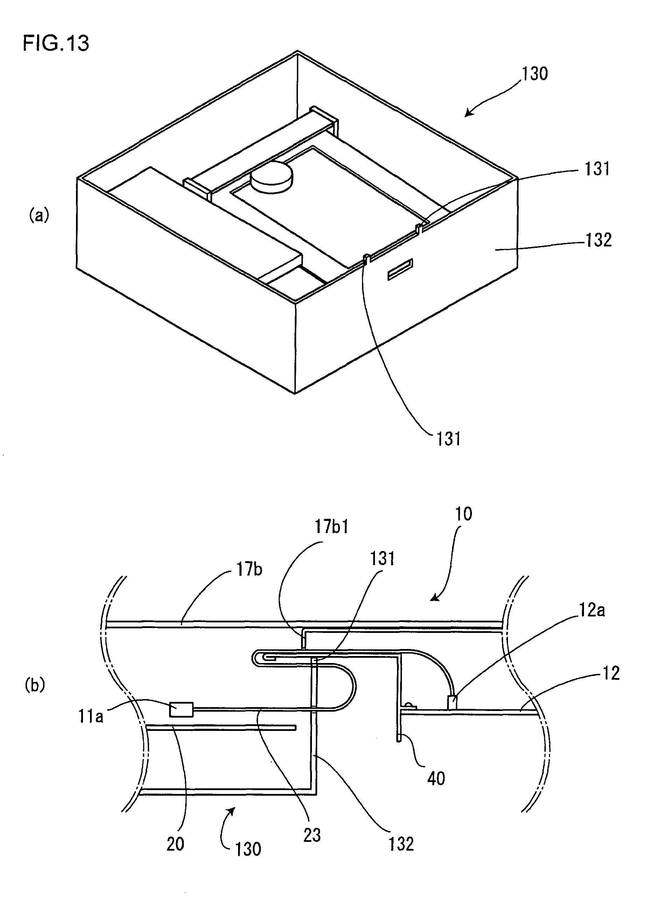

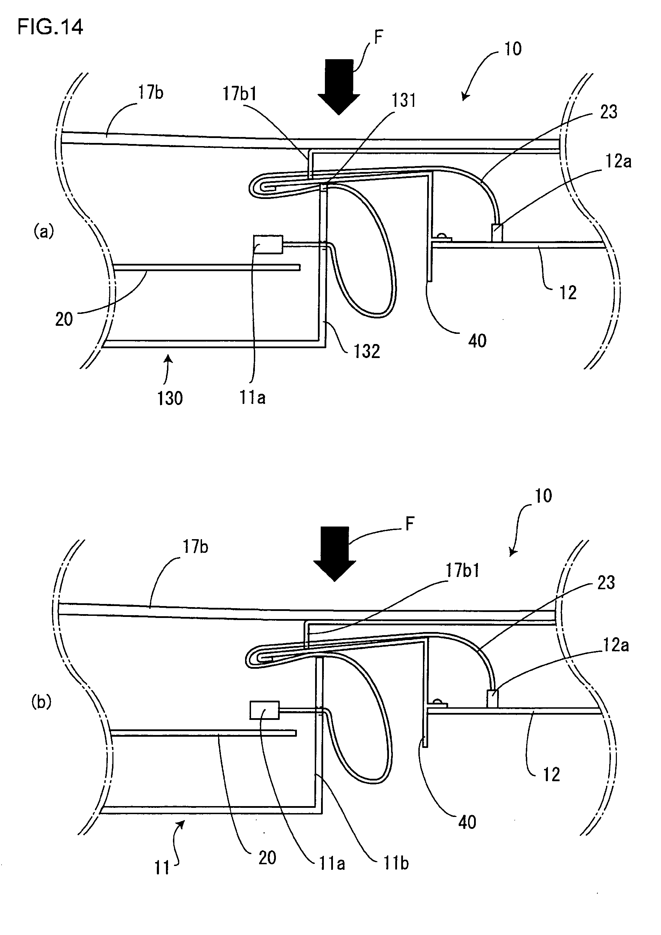

FIG. 13(a) is a top perspective view of a disk device of this embodiment, FIG. 13(b) is a schematic view illustrating the routing of an FFC which connects a disk device control substrate and a pickup section provided for the disk device. FIG. 14 is a schematic view illustrating conditions of a stopper and FFC inside the device when a load is applied from the outside to a back cabinet of a liquid crystal display device incorporating this disk device. The basic structure of the liquid crystal display device with a built-in disk device of this embodiment is the same as that of Embodiment 1, and therefore the components similar to those in Embodiment 1 are assigned the same reference numerals as those in Embodiment 1 and explanations thereof will be omitted here.

As shown in FIG. 13(a), convex parts 131 are formed at the top end of a frame side piece 132 (end of the frame side piece) of the disk device 130 of this embodiment. When provided in the LCD 10, the convex parts 131 are formed at positions facing a stopper 40 in such a way as to exceed in height the thickness of the FFC 23.

As shown in FIG. 14 ((a): convex parts are formed in the disk device, (b) : no convex parts are formed in the disk device), according to this embodiment, the convex parts 131 formed at the top end of the frame side piece 132 contact the stopper 40, preventing the FFC 23 from being caught between the stopper 40 and frame side piece 132. This can prevent problems of causing an adverse influence on the operation of a pickup section 11a, imposing a load on each member connected to the FFC 23 and damaging the FFC 23 itself.

### [Embodiment 6]

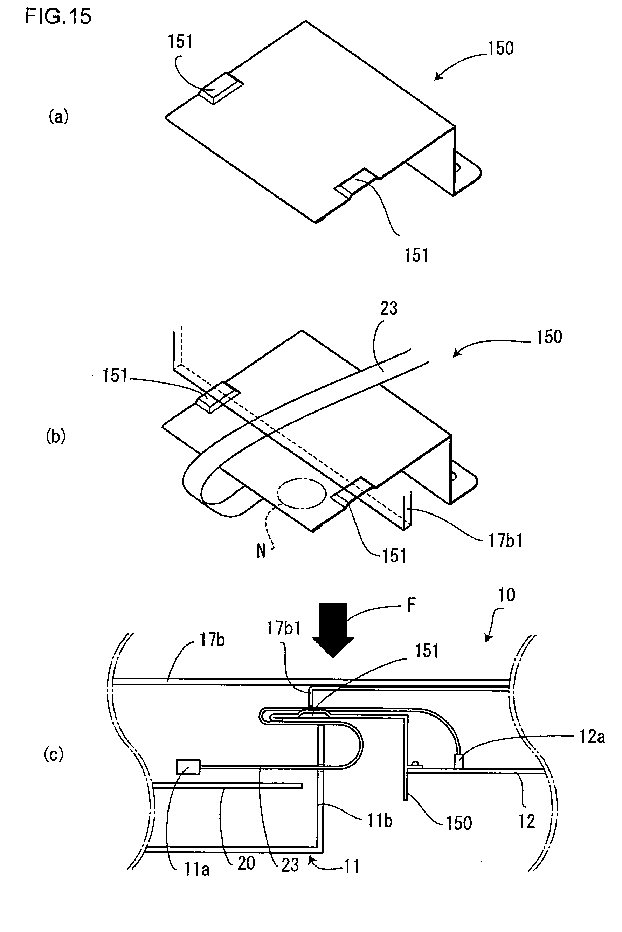

FIG. 15 illustrates a stopper provided for a disk device control substrate to retain the shape of an FFC, FIG. 15(a) is a top perspective view, (b) and (c) are schematic views illustrating conditions of the stopper and FFC inside the device when a load is applied from the outside to a back cabinet of a liquid crystal display device with a built-in disk device. The basic structure of the liquid crystal display device with a built-in disk device of this embodiment is the same as that of Embodiment 1 except the stopper, and therefore the components similar to those in Embodiment 1 are assigned the same reference numerals as those in Embodiment 1 and explanations thereof will be omitted here.

As shown in FIG. 15 (a), the stopper 150 of this embodiment corresponds to the stopper 40 shown in Embodiment 1 with convex parts 151 formed at parts thereof through drawing. When provided in an LCD 10, as shown in FIG. 15(c), the convex parts 151 are formed at positions facing a member 17b1 (protrusion) formed on the inner wall surface side of a back cabinet 17b in such a way as to exceed in height the thickness of the FFC 23.

When a load F is applied to the back cabinet 17b, the back cabinet 17b is bent in an inward direction of the device and the protrusion formed on the inner wall surface side of the back cabinet 17b contacts the stopper, if the protrusion contacts the stopper at a position other than the position where the FFC 23 is located (e.g. , part indicated by N in FIG. 15(b)), the FFC 23 is hardly caught between the protrusion formed on the inner wall surface side of the back cabinet 17b and stopper even when the back cabinet 17b is bent in an inward direction of the device, whereas if the protrusion contacts the stopper at the same position that the FFC 23 is located (e.g., the protrusion is a rib for reinforcing the cabinet and overlaps the position at which the FFC 23 is located as the member 17b1 shown in FIG. 15(b)), the FFC 23 may be caught between the protrusion formed on the inner wall surface side of the back cabinet 17b and the stopper. On the contrary, in the case of the stopper 150 of this embodiment, as shown in FIG. 15(b) and (c), the convex parts 151 formed in the stopper 150 contact the member 17b1 (protrusion) formed on the inner wall surface side of the back cabinet 17b, preventing the FFC 23 from being caught between the stopper 150 and back cabinet 17b. This can prevent a problem of damaging the FFC 23 (even when the FFC 23 is located between the stopper 150 and back cabinet 17b, this can hardly cause the operation of the pickup section 11a to be adversely affected).

In this embodiment, the convex parts 151 are formed only on the side facing the inner wall surface side of the back cabinet 17b, but in addition to this, it is also possible to form convex parts (convex parts 171 in Embodiment 4) on the side facing the frame side piece 11b or form convex parts (convex parts 131 in Embodiment 5) at the top end of the frame side piece 11b of the disk device (this would not be required when the stopper 150 is formed of a highly resistant member, which eliminates the necessity for taking into consideration a situation in which the stopper 150 is bent (that is, a situation in which the FFC 23 is caught between the stopper 150 and frame side piece 11b)).

### [Embodiment 7]

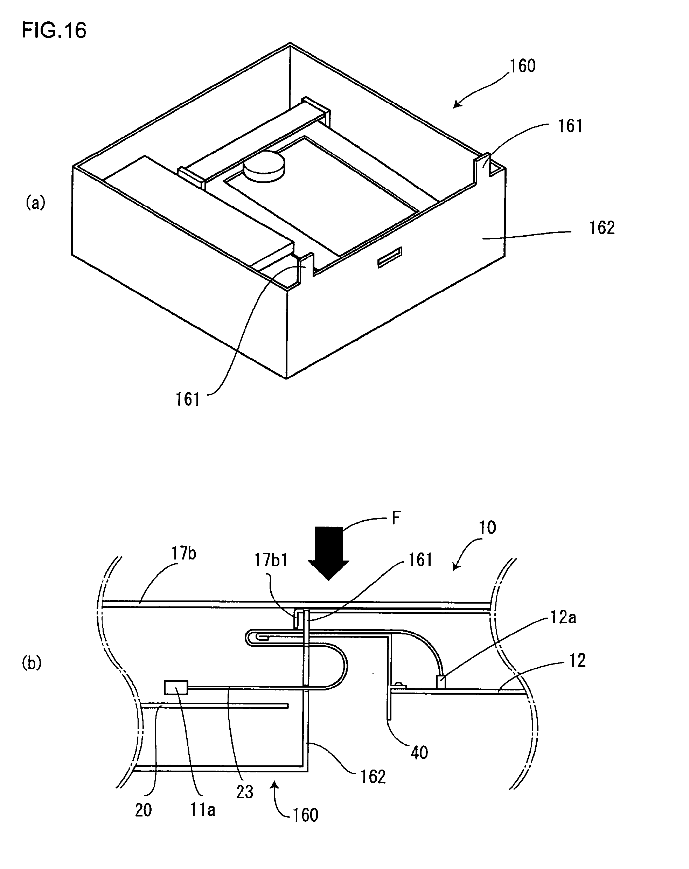

FIG. 16(a) is a top perspective view of a disk device of this embodiment and FIG. 16(b) is a schematic view illustrating conditions of a stopper and FFC inside the device when a load is applied from the outside to a back cabinet of the liquid crystal display device with a built-in disk device. The basic structure of the liquid crystal display device with a built-in disk device of this embodiment is the same as that of Embodiment 1, and therefore the components similar to those in Embodiment 1 are assigned the same reference numerals as those in Embodiment 1 and explanations thereof will be omitted here.

As shown in FIG. 16, in the disk device 160 of this embodiment, convex parts 161 are formed at the top end of a frame side piece 162 (end of the frame side piece). When provided inside an LCD 10, the convex parts 161 are formed at positions not facing a stopper 40 in such a way as to exceed in height the thickness of an FFC 23 placed between the inner wall surface of a back cabinet 17b and the top end of the frame side piece 162 (corresponding to thickness of two FFCs 23 in this embodiment) and the thickness of the stopper 40.

As shown in FIG. 16(b), according to this embodiment, the convex parts 161 formed at the top end of the frame side piece 162 contact the innerwall surface side of the back cabinet 17b or a member 17b1 formed on the inner wall surface side of the back cabinet 17b, preventing the FFC 23 from being caught between the stopper 40 and frame side piece 162 or between the stopper 40 and back cabinet 17b. This can prevent problems of causing an adverse influence on the operation of a pickup section 11a, imposing a load on each member connected to the FFC 23 and damaging the FFC 23 itself.

This embodiment assumes that the convex parts 161 are formed at the top end of the frame side piece 162 of the disk device, but it is also possible to form convex parts 161 on the inner wall surface side of the back cabinet 17b to produce similar effects.

The above described embodiments have been explained using an LCD as a specific example of the electronic device, but the present invention is not limited to this and the present invention is also applicable to a DVD reproducing/recording device, CD reproducing/recording device, MD reproducing/recording device, LD reproducing/recording device, etc. , and a composite machine combining these devices and a display device, etc., in which a disk device and disk device control substrate are arranged side by side.

## Claims

1. An electronic device with a built-in disk device comprising:
a disk device which reads and/or writes a signal from/to a diskmedium and a disk device control substrate which controls and drives said disk device and controls a signal input/output to/from said disk device, said disk device and said disk device control substrate being arranged side by side; and
a flexible flat cable which electrically connects a pickup section which moves to and fro in a radius direction of said disk medium to read and/or write a signal from said disk medium loaded in said disk device and said disk device control substrate,
**characterized in that** a slack portion provided for said flexible flat cable between said pickup section and said disk device control substrate to absorb the distance of reciprocating motion of said pickup section is provided with two or more bending sections.

2. An electronic device with a built-in disk device comprising:
a disk device which reads and/or writes a signal from/to a diskmedium and a disk device control substrate which controls and drives said disk device and controls a signal input/output to/from said disk device, said disk device and said disk device control substrate being arranged side by side; and
a flexible flat cable which electrically connects a pickup section which moves to and fro in a radius direction of said disk medium to read and/or write a signal from said disk medium loaded in said disk device and said disk device control substrate,
**characterized in that** a slack portion is provided for said flexible flat cable between said pickup section and said disk device control substrate to absorb the distance of reciprocating motion of said pickup section and a stopping/retaining section for retaining the shape of the slack portion of said flexible flat cable is provided at a connection point between said disk device control substrate and said flexible flat cable.

3. The electronic device with a built-in disk device according to claim 1 or 2, **characterized in that** the slack portion of said flexible flat cable is provided with bending sections and said bending sections have opposite curving directions so that said flexible flat cable becomes substantially a sigmoid curve.

4. The electronic device with a built-in disk device according to claim 1 or 2, **characterized in that** the slack portion of said flexible flat cable is provided with bending sections and the said bending sections have the same curving direction so that said flexible flat cable becomes substantially spiral.

5. The electronic device with a built-in disk device according to any one of claims 1 to 4, **characterized in that** the stopping/retaining section which retains the shape of the slack portion of said flexible flat cable is formed using an L-figured stopper.

6. The electronic device with a built-in disk device according to any one of claims 1 to 4, **characterized in that** the stopping/retaining section which retains the shape of the slack portion of said flexible flat cable is formed so as to allow said flexible flat cable to pass through a slit provided on a side of a frame which forms an outer frame of said disk device.

7. The electronic device with a built-in disk device according to any one of claims 1 to 4, **characterized in that** the stopping/retaining section which retains the shape of the slack portion of said flexible flat cable is formed using a hook provided on a side of a frame which forms an outer frame of said disk device.

8. The electronic device with a built-in disk device according to any one of claims 2 to 5, said flexible flat cable retained by said stopping/retaining section being disposed between an inner wall surface of a cabinet which constitutes a housing of said electronic device with a built-in disk device and an end of a frame side piece which forms an outer frame of said disk device,
**characterized in that** convex parts which exceed in height at least the thickness of said flexible flat cable are formed at parts of said stopping/retaining section facing the end of the frame side piece which forms the outer frame of said disk device.

9. The electronic device with a built-in disk device according to any one of claims 2 to 5, said flexible f lat cable retained by said stopping/retaining section being disposed between an inner wall surface of a cabinet which constitutes a housing of said electronic device with a built-in disk device and an end of a frame side piece which forms an outer frame of said disk device,
**characterized in that** convex parts which exceed in height at least the thickness of said flexible flat cable are formed at parts facing said stopping/retaining section at an end of the frame side piece which forms the outer frame of said disk device.

10. The electronic device with a built-in disk device according to any one of claims 2 to 5, said flexible flat cable retained by said stopping/retaining section being disposed between an inner wall surface of a cabinet which constitutes a housing of said electronic device with a built-in disk device and an end of a frame side piece which forms an outer frame of said disk device,
**characterized in that** convex parts which exceed in height at least the thickness of said flexible flat cable are formed on the side of said stopping/retaining section facing the inner wall surface of said cabinet.

11. The electronic device with a built-in disk device according to any one of claims 1 to 7, said flexible flat cable being disposed between an inner wall surface of a cabinet which constitutes a housing of said electronic device with a built-in disk device and an end of a frame side piece which forms an outer frame of said disk device,
**characterized in that** convex parts which exceed in height at least the thickness of said flexible flat cable disposed between the inner wall surface of said cabinet and the end of said frame side piece or the thickness of said flexible flat cable and said stopping/retaining section are formed at the end of the frame side piece which forms the outer frame of said disk device.

12. The electronic device with a built-in disk device according to any one of claims 1 to 7, said flexible flat cable being disposed between an inner wall surface of a cabinet which constitutes a housing of said electronic device with a built-in disk device and an end of a frame side piece which forms an outer frame of said disk device,
**characterized in that** convex parts which exceed in height at least the thickness of said flexible flat cable disposed between the inner wall surface of said cabinet and the end of said frame side piece or the thickness of said flexible flat cable and said stopping/retaining section are formed at parts of the inner wall surface of said cabinet facing the end of the frame side piece which forms the outer frame of said disk device.
